# FASCICULE DE BREVET EUROPEEN

(11) **EP 3 696 645 B1**
(45) Date de publication et mention de la délivrance du brevet: **08.09.2021**
(21) Numéro de dépôt: 20156055.4
(22) Date de dépôt: 07.02.2020
(51) Int. Cl.: G05F 1/56

(54) **DISPOSITIF DE FOURNITURE D'UNE PUISSANCE D'ALIMENTATION**
LIEFERVORRICHTUNG EINER STROMEINSPEISELEISTUNG
DEVICE FOR SUPPLYING A POWER SUPPLY

(30) Priorité: 12.02.2019 FR 1901411
(43) Date de publication de la demande: 19.08.2020
(73) Titulaire: STMicroelectronics (Grenoble 2) SAS, 38000 Grenoble (FR); STMicroelectronics (ALPS) SAS, 38000 Grenoble (FR)
(72) Inventeur: CAMIOLO, Jean, 38120 SAINT-EGREVE (FR); PONS, Alexandre, 38220 VIZILLE (FR)
(74) Mandataire: Cabinet Beaumont

(56) Documents cités:
- WO-A2-2018/009747
- JP-A- 2013 027 102
- US-A1- 2009 115 379
- US-A1- 2015 100 812

## Description

### Domaine technique

La présente demande concerne de manière générale les dispositifs de fourniture, à partir d'une source d'alimentation, d'une puissance d'alimentation à une charge. La demande concerne plus particulièrement le domaine des câbles de transmission d'énergie entre une source d'alimentation et une charge, notamment les câbles et connecteurs de type USB-C utilisant la technologie USB-PD. Des exemples de dispositifs de transmission de puissance sur câble USB peuvent être trouvés dans les documents JP2013027102 ou US2015100812.

### Technique antérieure

Bien qu'aujourd'hui le sans-fil soit un des axes majeurs de la recherche dans le domaine de l'échange d'énergie et de données, les câbles semblent toujours être le moyen le plus fiable pour connecter plusieurs appareils électroniques, que ce soit pour échanger des données ou pour alimenter ou recharger un ou plusieurs appareils électroniques.

Parmi les différents types de câbles et connecteurs de la norme USB, le type USB-C est l'un des types qui permet l'échange de données et d'énergie. La technologie USB-PD (de l'anglais "POWER DELIVERY") est une technologie de rechargement qui s'adapte sur les câbles et connecteurs de type USB-C. Cette technologie permet la gestion de l'alimentation d'appareils électroniques.

Il serait souhaitable de pouvoir améliorer au moins en partie certains aspects des dispositifs de fourniture, à partir d'une source de puissance, d'une puissance d'alimentation à une charge par l'intermédiaire d'un câble, en particulier par l'intermédiaire d'un câble USB-C adapté à la technologie USB-PD.

### Résumé de l'invention

Un mode de réalisation pallie tout ou partie des inconvénients des dispositifs connus de fourniture, à partir d'une source de puissance, d'une puissance d'alimentation à une charge.

Un mode de réalisation prévoit un dispositif comprenant : une première borne destinée à recevoir une première tension continue ; un interrupteur reliant sélectivement la première borne à une deuxième borne de sortie du dispositif ; un circuit de commande de l'interrupteur comprenant une troisième borne destinée à recevoir une deuxième tension continue ; et un régulateur linéaire de tension à faible chute, LDO, connecté entre les première et troisième bornes, dans lequel le régulateur est configuré pour fournir la deuxième tension à partir de la première tension, et le circuit de commande de l'interrupteur est configuré pour comparer la première tension à la deuxième tension, et pour commander l'état ouvert ou fermé de l'interrupteur en fonction du résultat de la comparaison.

Selon un mode de réalisation, le circuit de commande de l'interrupteur comprend un comparateur à hystérésis dont une première entrée est reliée à la première borne, dont une deuxième entrée est connectée à la troisième borne, et dont une sortie est couplée à une borne de commande l'interrupteur.

Selon un mode de réalisation, lorsque la première tension augmente à partir d'une valeur de consigne, le régulateur est configuré pour maintenir la deuxième tension inférieure ou égale à une tension de seuil, de préférence supérieure à la valeur de consigne.

Selon un mode de réalisation, la tension de seuil est déterminée à partir de la valeur de consigne.

Selon un mode de réalisation, le régulateur comprend : un transistor, de préférence un transistor de puissance, dont les bornes de conduction sont respectivement connectées aux première et troisième bornes ; un premier circuit configuré pour commander le transistor à partir d'un signal disponible sur une quatrième borne ; et un deuxième circuit configuré pour fournir, à la quatrième borne, un signal représentatif de l'écart entre la valeur de la deuxième tension et la valeur de seuil.

Selon un mode de réalisation, le deuxième circuit comprend un amplificateur différentiel dont une entrée, de préférence non inverseuse, est configurée pour recevoir une tension représentative de la valeur de seuil, dont une autre entrée, de préférence inverseuse, est couplée à la troisième borne, et dont une sortie est connectée à la quatrième borne.

Selon un mode de réalisation, le dispositif comprend en outre un troisième circuit configuré pour activer le deuxième circuit lorsque la deuxième tension devient supérieure à une tension limite.

Selon un mode de réalisation, le troisième circuit est configuré pour activer l'amplificateur différentiel du deuxième circuit lorsque la deuxième tension est sensiblement supérieure ou égale à la tension limite.

Selon un mode de réalisation, le dispositif comprend en outre un circuit de démarrage du régulateur, alimenté électriquement par la première tension.

Selon un mode de réalisation, le circuit de démarrage est configuré pour fournir, à la quatrième borne et alors que le deuxième circuit est inactif, un signal tel que la deuxième tension augmente avec la première tension jusqu'à la tension limite.

Selon un mode de réalisation, le signal fourni à la quatrième borne par le circuit de démarrage est représentatif de l'écart entre la deuxième tension et une tension de référence.

Selon un mode de réalisation, le circuit de démarrage comprend un amplificateur différentiel, de préférence un amplificateur différentiel faible puissance, dont une entrée, de préférence non inverseuse, est couplée à une source de la tension de référence, dont une autre entrée, de préférence inverseuse, est couplée à la deuxième borne, et dont une sortie est connectée à la quatrième borne, l'amplificateur différentiel étant alimenté par la première tension.

Selon un mode de réalisation, la source de la tension de référence est alimentée par la première tension, la source de tension comprenant de préférence une ou plusieurs diodes dont la ou les tensions de seuil déterminent la tension de référence.

Selon un mode de réalisation, la première borne et/ou la borne de commande de l'interrupteur sont couplées chacune à une borne d'application d'un potentiel de référence, de préférence la masse, par une diode respective, de préférence une diode Zener.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique illustrant une connexion entre une source d'alimentation et un dispositif électronique ;
la figure 2 est une vue schématique illustrant un mode de réalisation d'un dispositif électronique de fourniture d'alimentation électrique au dispositif électronique de la figure 1 ;
la figure 3 illustre l'évolution de tensions dans le dispositif de la figure 2 ; et
la figure 4 illustre, de manière plus détaillée et sous la forme d'un circuit électronique, un mode de réalisation du dispositif de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la gestion d'une phase de négociation concernant la puissance d'alimentation à fournir entre un dispositif et une source d'alimentation n'est pas détaillée. De plus, seuls les aspects pertinents des technologies USB-C et USB-PD sont décrits, les autres aspects s'adaptant sans modifications. Notamment, la fonction d'échange de données via un câble de type USB-PD n'est pas décrite, les modes de réalisation décrits étant compatibles avec la fonction d'échange de données des câbles USB-PD usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

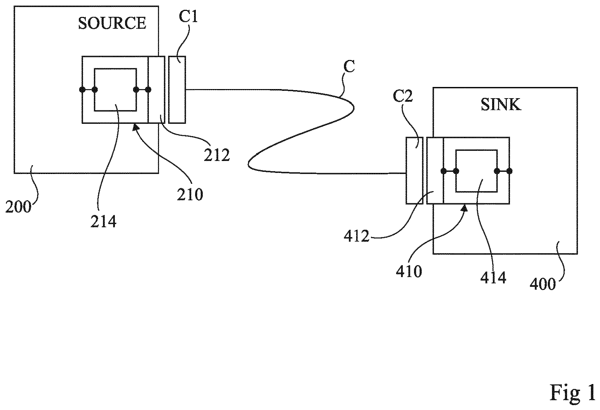

La figure 1 est une vue schématique illustrant une transmission d'énergie entre une source d'alimentation (SOURCE) 200 et un dispositif électronique (SINK) 400 connectés par l'intermédiaire d'un câble C, par exemple de type USB-C équipé de la technologie USB-PD ou USB Power Delivery. La source d'alimentation 200 est par exemple le secteur ou une alimentation continue. La source d'alimentation 200 peut être un ordinateur, une batterie portable, etc. ou tout autre dispositif électronique adapté à alimenter un dispositif et/ou à recharger une batterie.

Le câble C comprend, à chacune de ses extrémités un connecteur C1, C2, dans cet exemple adapté à la technologie USB-PD. Les connecteurs C1, C2 sont généralement identiques.

La source d'alimentation 200, respectivement le dispositif 400, comprend un élément de raccordement 210, respectivement 410, comprenant un connecteur 212, respectivement 412, et une interface de connexion 214, respectivement 414. Chaque connecteur 212, 412 est adapté pour coopérer avec un connecteur C1, C2 du câble C. Chaque interface de connexion 214, 414 relie le connecteur 212, 412 au reste de la source d'alimentation 200, respectivement du dispositif 400. Les interfaces de connexion 214, 414 permettent d'adapter la puissance d'alimentation fournie par la source d'alimentation 200 en fonction de la puissance d'alimentation demandée par le dispositif 400. Les interfaces 214, 414 sont généralement identiques.

Lors d'une connexion, une communication s'établit entre le dispositif 400 et la source d'alimentation 200 pour décider de la puissance électrique d'alimentation nécessaire au dispositif 400 pour pouvoir être alimenté et/ou rechargé. Plus particulièrement, le dispositif 400 indique la puissance minimale requise pour son fonctionnement et la source d'alimentation 200 indique les puissances d'alimentation qu'elle est capable de fournir. Une négociation, par exemple gérée par la technologie USB-PD, s'entame alors pour définir quelle puissance la source d'alimentation 200 fournira au dispositif 400. Une fois cette négociation terminée, l'interface de connexion 214 adapte la puissance d'alimentation de la source d'alimentation 200 conformément au résultat de la négociation, puis l'alimentation du dispositif 400 débute. Plus particulièrement, l'interface 214 comprend un convertisseur de puissance (non représenté en figure 1), de préférence un convertisseur de tension continu-continu (DC/DC) ou alternatif-continu (AC/DC), commandé pour adapter la puissance de la source 200 conformément au résultat de la négociation, c'est-à-dire pour adapter la puissance de la source à la puissance négociée.

A titre d'exemple, les puissances d'alimentation que la source 200 est capable de fournir sont sélectionnées parmi une liste de puissances d'alimentation enregistrée dans l'interface. De préférence, cette liste est prédéfinie, par exemple par une norme. Chaque puissance d'alimentation de cette liste est caractérisée par plusieurs valeurs, notamment par la valeur de la tension correspondant à cette puissance.

Toutefois, la puissance disponible en sortie du convertisseur de puissance peut être supérieure à la puissance négociée. En particulier, la tension délivrée par le convertisseur peut être supérieure à la tension caractérisant la puissance d'alimentation négociée, la tension caractérisant la puissance d'alimentation négociée constituant une valeur de consigne de la tension disponible en sortie du convertisseur. Cela peut entraîner une dégradation du dispositif 400. Pour pallier cette dégradation du dispositif 400, dans les modes de réalisation décrits, on prévoit d'isoler électriquement le connecteur C1 de la sortie du convertisseur de puissance lorsque la tension qu'il délivre s'éloigne de la valeur de consigne et dépasse une tension de seuil. Lorsqu'une puissance d'alimentation a été négociée, la valeur de la tension de seuil est de préférence déterminée à partir de la valeur de la tension correspondant à cette puissance négociée, c'est-à-dire à partir de la valeur de consigne de la tension délivrée par le convertisseur. Tant qu'aucune puissance n'a été négociée, la valeur de la tension de seuil est de préférence déterminée par la plus petite de tension caractérisant les puissances d'alimentation de la liste enregistrée dans l'interface 214, cette plus petite tension constituant, ici aussi, une valeur de consigne de la tension délivrée par le convertisseur. A titre d'exemple, cette plus petite tension est définie par une norme et est par exemple égale à 5 V.

Dans les modes de réalisation décris, l'isolation électrique entre le connecteur C1 et le convertisseur de puissance, lorsque la tension qu'il délivre dépasse la tension de seuil, est mise en oeuvre par des composants électroniques de l'interface 214 qui sont alimentés électriquement à partir de la tension délivrée par le convertisseur de puissance. Dans ces modes de réalisation, on prévoit de protéger ces composants contre une augmentation de la tension délivrée par le convertisseur de puissance qui serait susceptible de détériorer ces composants. Cela permet d'éviter que ces composants ne soient détruits lors d'une telle augmentation de tension et ne puissent alors plus commander l'isolation électrique entre le dispositif d'adaptation de puissance et le connecteur C1.

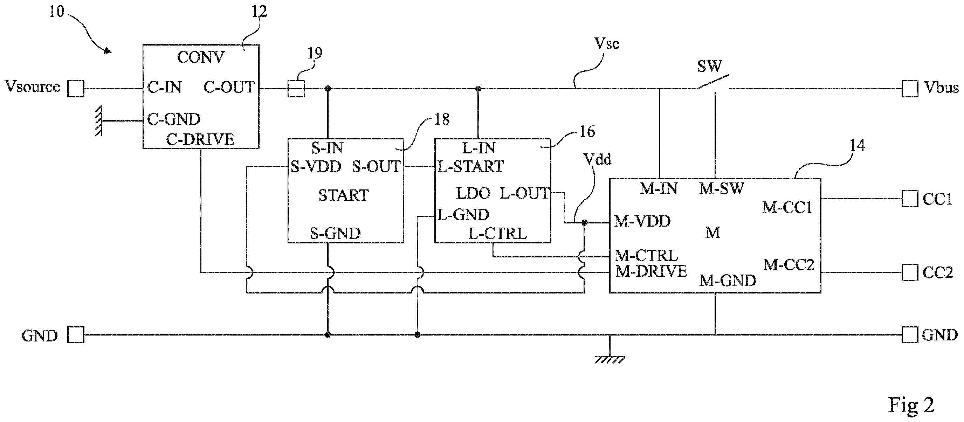

La figure 2 est une vue schématique illustrant un mode de réalisation d'un dispositif électronique 10 compris dans l'interface 214, 414 de la source 200 et du dispositif 400 de la figure 1. Plus particulièrement, un dispositif 10 est positionné dans chaque interface de connexion des dispositifs électroniques reliés par le câble C, mais ce dispositif 10 n'est actif que dans l'interface de connexion du dispositif jouant le rôle de source d'alimentation, dans le cas illustré en figure 1, seul le dispositif 10 de l'interface de connexion 214 est actif. Ainsi, bien que le dispositif 10 soit ici décrit en relation avec l'interface 214 de la source 200 et le connecteur C1, ce qui est indiqué s'applique au dispositif 10 de l'interface 414.

Le dispositif 10 comprend au moins deux bornes d'entrée connectées à une source d'alimentation, ici le reste de la source d'alimentation 200. Une première borne reçoit une tension Vsource de la source d'alimentation 200, référencée par rapport à un potentiel de référence GND, par exemple la masse, reçu par une deuxième borne. Le dispositif 10 comprend en outre une première borne de sortie fournissant une tension d'alimentation Vbus, référencée par rapport au potentiel de référence GND reçu par une deuxième borne de sortie, et au moins une borne de communication. Ces bornes de sortie sont toutes destinées à être reliées au connecteur C1, ce qui permet ensuite la liaison avec le dispositif 400, via le connecteur C2 et l'interface 414 du dispositif 400. Dans ce mode de réalisation, le dispositif 10 comprend deux bornes de communication CC1, CC2. Un avantage d'avoir deux bornes de communication est que, dans le cas où ces bornes sont positionnées de façon symétrique sur le connecteur C1, cela permet de fabriquer des connecteurs réversibles, c'est-à-dire des connecteurs, par exemple de forme rectangulaire, que l'on peut brancher dans un premier sens et dans un deuxième sens inverse au premier.

Le dispositif 10 comprend un convertisseur (CONV) 12, un interrupteur SW, un module ou circuit de commande (M) 14 de l'interrupteur SW, un régulateur linéaire de tension (LDO) 16, de préférence un régulateur linéaire à faible chute de tension ("Low-DropOut"), et, dans ce mode de réalisation, un circuit de démarrage (START) 18 du régulateur 16.

Le convertisseur 12 est par exemple un convertisseur buck adapté à convertir une tension Vsource continue en une tension d'alimentation Vsc continue plus faible, par exemple lorsque la source d'alimentation 200 est une source d'alimentation continue, par exemple un dispositif électronique adapté à alimenter et/ou recharger un autre dispositif électronique, comme un ordinateur ou une batterie externe. Le convertisseur 12 comprend :
- une borne d'entrée C-IN recevant la tension Vsource ;
- une borne C-GND recevant le potentiel de référence GND ;
- une borne de commande C-DRIVE recevant un signal de commande représentatif de la valeur de consigne de la tension Vsc ; et
- une borne de sortie C-OUT fournissant, à partir d'une alimentation électrique de la source 200, une tension convertie ou adaptée Vsc à une borne ou noeud 19 du dispositif 10, la borne C-OUT étant connectée à la borne 19.

Dans une variante de réalisation non illustrée, le convertisseur 12 est externe au dispositif 10. Dans ce cas, la borne 19 constitue l'entrée du dispositif 10 destinée à recevoir la tension Vsc.

L'interrupteur SW a une de ses bornes reliée à la borne 19, et son autre borne est connectée à la borne de sortie fournissant la tension Vbus. L'interrupteur SW est commandé, ou piloté, par le module de commande 14. Lorsque l'interrupteur SW est ouvert, la borne de sortie C-OUT du convertisseur, donc la borne 19, est isolée électriquement de la borne de sortie du dispositif 10 qui fournit la tension Vbus.

Le module de commande 14 est configuré pour observer la tension Vsc et commander l'ouverture de l'interrupteur SW lorsque la tension Vsc dépasse une tension de seuil. Le module de commande 14 comprend :
- une borne d'entrée M-IN recevant la tension Vsc, ou du moins une tension sensiblement égale à la tension Vsc, la tension Vsc étant référencée par rapport au potentiel de référence GND ;
- une borne M-GND recevant le potentiel de référence GND ;
- au moins une borne de communication reliée à la borne de communication du dispositif 10 (dans le cas illustré en figure 2, le module de commande 14 comprend deux bornes de communication M-CC1, M-CC2) ;
- une borne de commande M-DRIVE du convertisseur 12, transmettant un signal de commande à la borne C-DRIVE du convertisseur 12, le signal de commande étant représentatif de la valeur de consigne de la tension Vsc fournie par le convertisseur 12 ;
- une borne de commande M-CTRL du régulateur 16, transmettant un signal de commande au régulateur 16 représentatif de la valeur de consigne de la tension Vsc ;
- une borne de commande M-SW de l'interrupteur SW transmettant un signal de commande à l'interrupteur SW ; et
- une borne M-VDD recevant une tension de sortie Vdd du régulateur 16, cette tension permettant notamment d'alimenter électriquement le module 14.

Le régulateur de tension 16 est configuré pour fournir, à partir de la tension Vsc, la tension Vdd à la borne M-VDD du module 14. Plus particulièrement, après une phase de démarrage, le régulateur 16 est configuré pour fournir une tension régulée Vdd égale à la tension de seuil, cette tension de seuil étant déterminée à partir de la valeur de consigne de la tension Vsc. De préférence, la tension de seuil est proportionnelle et supérieure à la valeur de consigne de la tension Vsc, de sorte que la tension Vdd est sensiblement égale à la tension Vsc si la tension Vsc est inférieure ou égale à la tension de seuil, et égale à la tension de seuil sinon. Le régulateur de tension comprend :
- une borne L-IN recevant la tension Vsc ;
- une borne L-GND recevant le potentiel de référence GND ;
- une borne L-OUT fournissant la tension Vdd ;
- une borne L-CTRL connectée à la borne M-CTRL du module 14 pour recevoir le signal de commande correspondant ; et
- dans ce mode de réalisation, une borne L-START recevant un signal de démarrage fourni par le circuit de démarrage 18.

Dans ce mode de réalisation, le circuit de démarrage 16 est configuré pour démarrer le régulateur 16, ou, autrement dit, pour commander le régulateur 16 lors d'une phase de démarrage de sorte qu'il fournisse une tension Vdd non nulle à la borne M-VDD. Plus particulièrement, durant la phase de démarrage, le circuit 18 commande le régulateur 16 de sorte que la tension Vdd ne dépasse pas une tension limite. Le circuit de démarrage 18 comprend :
- une borne S-IN recevant la tension Vsc, ou du moins une tension sensiblement égale à la tension Vsc, la borne S-IN étant reliée à la borne C-OUT, donc à la borne 19 ;
- une borne S-GND recevant le potentiel de référence GND ;
- une borne S-OUT fournissant un signal de démarrage à la borne L-START du régulateur 16 ; et
- une borne S-VDD recevant une tension représentative de la tension Vdd, la borne S-VDD recevant la tension Vdd dans l'exemple de la figure 2.

Dans une variante de réalisation non illustrée, le circuit 18 fait partie du régulateur 16.

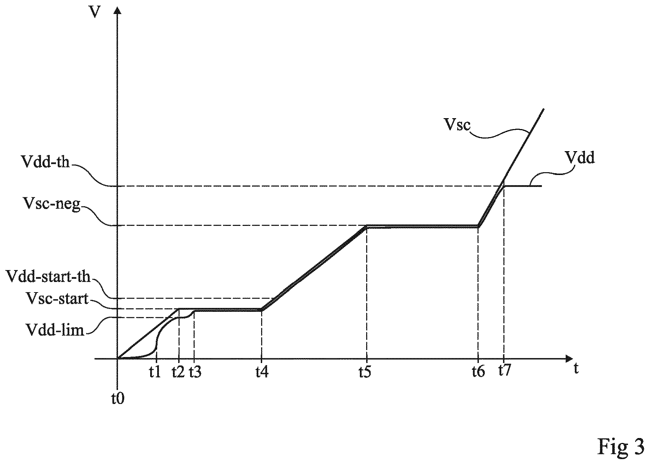

Un mode de mise en oeuvre, au moyen du dispositif 10, d'un procédé d'alimentation d'un dispositif 400 va maintenant être décrit en relation avec la figure 3.

La figure 3 illustre l'évolution, en fonction du temps t, des tensions Vsc et Vdd, en volt V, dans l'interface 214.

Entre des instants t0 et t2, l'instant t0 marquant le début d'une phase de démarrage, la tension Vsc augmente à partir d'une valeur nulle. A un instant t1 compris entre les instants t0 et t2, la tension Vsc non nulle présente sur la borne S-IN entraîne la fourniture, par le circuit 18, d'un signal de démarrage au régulateur 16. Le régulateur 16 fournit alors une tension Vdd non nulle à la borne M-VDD, la tension Vdd augmentant avec la tension Vsc à partir de l'instant t1. Dès que la tension Vdd est suffisante pour alimenter le module 14, par exemple entre les instants t1 et t2, celui-ci commande le convertisseur 12 de sorte qu'il fournisse une tension Vsc à une valeur de consigne Vsc-start, par exemple la plus petite valeur de tension Vsc caractérisant les puissances d'alimentation de la liste enregistrée dans l'interface 214, par exemple 5 V. Dans l'exemple de la figure 3, la tension Vsc se stabilise à la valeur de consigne Vsc-start à partir de l'instant t1.

En outre, pendant la phase de démarrage, dès que le circuit 18 fournit le signal de démarrage au régulateur 16 (instant t1), le régulateur 16 est commandé par ce signal de sorte que la tension Vdd ne dépasse pas une valeur limite Vdd-lim. Dans l'exemple de la figure 3, la tension Vdd se stabilise à la valeur Vdd-lim à l'instant t2. La valeur Vdd-lim est inférieure à la valeur de consigne Vsc-start, par exemple égale à 4 V. La valeur Vdd-lim est telle que le module 14 est correctement alimenté. Autrement dit, la valeur Vdd-lim est supérieure ou égale à la tension minimale d'alimentation du module 14.

Par ailleurs, pendant la phase de démarrage, entre l'instant t0 et un instant t3 postérieur à l'instant t2 ou confondu avec l'instant t2, l'interrupteur SW est maintenu ouvert par le module 14. A titre d'exemple, tant que la tension Vdd est inférieure à la tension d'alimentation minimale du module 14, le module 14 n'est pas en mesure de générer un signal de commande avec un niveau de tension suffisant pour fermer l'interrupteur SW, et, quand la tension Vdd devient supérieure ou égale à la tension minimale d'alimentation du module 14, ce dernier maintient le niveau de tension du signal de commande de l'interrupteur SW à une valeur telle que l'interrupteur SW reste ouvert.

A partir de l'instant t3 qui marque la fin de la phase de démarrage, le régulateur n'est plus commandé par le circuit de démarrage 18, mais par le signal de commande que lui fournit le module 14. Le régulateur 16 fournit alors une tension Vdd inférieure à une tension de seuil Vdd-start-th. La tension Vdd-start-th est déterminée par la valeur de consigne Vsc-start, à partir du signal de commande fourni par le module 14 au régulateur 16. La valeur de la tension de seuil Vdd-start-th est supérieure à la valeur de consigne Vsc-start. De préférence, la valeur de la tension de seuil Vdd-start-th est proportionnelle à la valeur de consigne Vsc-start.

Ainsi, à partir de l'instant t3, la tension Vdd est égale, aux chutes de tension près dans le régulateur 16, à la tension Vsc si la tension Vsc est inférieure ou égale à la tension de seuil Vdd-start-th, et à la tension Vdd-start-th sinon.

En outre, à partir de l'instant t3, le module 14 ferme l'interrupteur SW et est configuré pour ouvrir l'interrupteur si la tension Vsc devient supérieure à la tension Vdd majorée d'une valeur d'hystérésis.

A partir de l'instant t3, une phase de négociation d'une puissance d'alimentation que la source 200 fournira au dispositif 400 est mise en oeuvre.

Lors de cette phase de négociation, entre l'instant t3 et un instant postérieur t4 en figure 3, le dispositif 400 envoie à la source d'alimentation 200, par l'intermédiaire des bornes de communication CC1, CC2 et du câble C, des informations concernant la puissance d'alimentation nécessaire à lui fournir. Le module de commande 14, quant à lui, fournit au dispositif 400, par l'intermédiaire des bornes de communication CC1, CC2 et du câble C, les puissances d'alimentation que la source d'alimentation 200 est capable de fournir au dispositif 400. Le module de commande 14 négocie ensuite avec le dispositif 400, par l'intermédiaire des bornes de communication CC1, CC2, pour choisir l'une de ces puissances d'alimentation.

A titre d'exemple, le module 14 détermine les puissances que la source 200 est capable de fournir à partir de mesures de la tension Vsource et/ou Vsc, et de la liste de puissances d'alimentation enregistrée dans l'interface. Chacune des puissances de la liste est définie par plusieurs valeurs, par exemple le courant d'alimentation, la tension d'alimentation, le courant d'alimentation minimal, la tension d'alimentation minimale etc. A titre d'exemple, le module 14 détermine, parmi cette liste, les puissances d'alimentation que la source 200 est en mesure de fournir en comparant la tension mesurée Vsource et/ou Vsc avec chaque tension d'alimentation minimale des puissances de la liste.

Selon un autre exemple, le module 14 détermine les puissances que la source 200 est capable de fournir uniquement à partir de la liste de puissances d'alimentation enregistrée dans l'interface. On considère alors que la source 200 est capable de fournir chacune des puissances de la liste.

A l'instant t4, le module 14 met à jour le signal de commande envoyé à la borne C-DRIVE du convertisseur 12, de sorte que le convertisseur fournisse une tension Vsc ayant une valeur Vsc-neg associée à la puissance d'alimentation choisie ou négociée. La valeur Vsc-neg constitue donc la nouvelle valeur de consigne de la tension Vsc.

A l'instant t4, le module 14 met également à jour le signal de commande envoyé à la borne L-CTRL du régulateur 16, ce signal étant représentatif de la consigne Vsc-neg. Le régulateur 16 fournit alors une tension Vdd inférieure à une tension de seuil Vdd-th, déterminée par la valeur de consigne Vsc-neg, à partir du signal de commande fourni par le module 14 au régulateur 16. La valeur de la tension de seuil Vdd-th est supérieure à la valeur de consigne Vsc-neg. De préférence, la valeur de la tension de seuil Vdd-th est proportionnelle à la valeur de consigne Vsc-neg.

Ainsi, à partir de l'instant t4, la tension Vdd est égale, aux chutes de tension près dans le régulateur 16, à la tension Vsc si la tension Vsc est inférieure ou égale à la tension de seuil Vdd-th, et à la tension Vdd-th sinon.

Dans l'exemple de la figure 3, la valeur de consigne Vsc-neg est supérieure à la valeur de consigne Vsc-start, par exemple égale à 20 V. Ainsi, de l'instant t4 à un instant postérieur t5, les tensions Vsc et Vdd augmentent jusqu'à être égales à la valeur de consigne Vsc-neg. A l'instant t5, la valeur de la tension Vsc est égale à la valeur de consigne Vsc-neg, et la tension Vdd est égale à la tension Vsc, aux chutes de tensions près dans le régulateur 16. A partir de l'instant t5, le dispositif 400 est donc alimenté, via le câble C, par la tension Vsc à la valeur de consigne Vsc-neg correspondant à la puissance négociée.

A un instant t6 postérieur à l'instant t5, la tension Vsc augmente sans que la valeur de consigne Vsc-neg n'ait été modifiée, par exemple suite à un défaut de fonctionnement du convertisseur 12. Tant que la tension Vsc est inférieure à la tension de seuil Vdd-th, la tension Vdd est égale à la tension Vsc, aux chutes de tensions près dans le régulateur 16. A partir d'un instant t7 postérieur à l'instant t6, la tension Vsc est supérieure à la tension de seuil Vdd-th et la tension Vdd se stabilise alors à une valeur égale à celle de la tension de seuil Vdd-th.

Ainsi, même si la tension Vsc augmente jusqu'à des valeurs susceptibles d'endommager les composants électroniques du module 14, la tension d'alimentation Vdd reçue par le module 14 reste inférieure ou égale à la tension de seuil Vdd-th, la valeur de la tension Vdd-th étant déterminée pour ne pas détériorer le module 14. En outre, bien que cela ne soit pas représenté en figure 3, un dispositif passif de protection contre les surtensions, comprenant par exemple une ou plusieurs diodes, est de préférence prévu au niveau de la borne M-IN du module 14, de préférence entre la borne M-IN et une borne au potentiel de référence GND. Ainsi, lorsque la tension Vsc dépasse le seuil de déclenchement du dispositif de protection, la tension présente sur la borne M-IN du module 14 est limitée par le dispositif passif de protection contre les surtensions, ce qui permet d'éviter qu'une tension Vsc susceptible de détériorer le module 14 ne soit présente sur la borne M-IN.

En outre, peu après l'instant t7, le module 14 détecte que la tension Vsc est supérieure à la tension Vdd majorée de la valeur d'hystérésis, c'est-à-dire ici que la tension Vsc est supérieure à la tension de seuil Vdd-th majorée de la valeur d'hystérésis. Le module 14 commande alors l'ouverture de l'interrupteur SW, ce qui permet de protéger le dispositif 400 contre l'augmentation de la tension Vsc au-delà de la tension de seuil Vdd-th.

Bien que cela ne soit pas illustré en figure 3, si entre les instants t0 et t3, la tension Vsc augmente, par exemple suite à un défaut de fonctionnement du convertisseur 12, jusqu'à des valeurs supérieures à la valeur de consigne Vsc-start, la tension Vdd reçue par le module 14 reste inférieure ou égale à la tension limite Vdd-lim. Cela permet de protéger le module 14 contre des augmentations de la tension Vsc qui seraient susceptibles d'endommager le module 14. Le dispositif 400 est quant à lui protégé contre ces augmentations de la tension Vsc par le fait que l'interrupteur SW soit ouvert.

Bien que cela ne soit pas non plus illustré en figure 3, si une telle augmentation de la tension Vsc se produit entre les instants t3 et t4, le module 14 est protégé du fait que la tension Vdd qu'il reçoit reste inférieure ou égale à la tension de seuil Vdd-start-th. Le dispositif 400 est, quant à lui, protégé par l'ouverture de l'interrupteur SW commandée par le module 14. En effet, le module 14 ouvre l'interrupteur SW lorsque la tension Vsc devient supérieure à la tension Vdd majorée de la valeur d'hystérésis, c'est-à-dire ici si la tension Vcs devient supérieure à la tension de seuil Vdd-start-th majorée de la valeur d'hystérésis. Ainsi, la tension fournie au dispositif 400 ne peut pas excéder Vdd-start-th. On notera que le dispositif 10 à un fonctionnement similaire entre les instants t3 et t4 et à partir de l'instant t4. Plus particulièrement, entre les instants t3 et t4 la valeur de consigne de la tension Vsc est Vsc-start, la tension de seuil étant alors Vdd-start-th et étant déterminée par la valeur Vsc-start, alors que, à partir de l'instant t4, la valeur de consigne de la tension Vsc est Vsc-neg, la tension de seuil étant alors Vdd-th et étant déterminée par la valeur Vsc-neg.

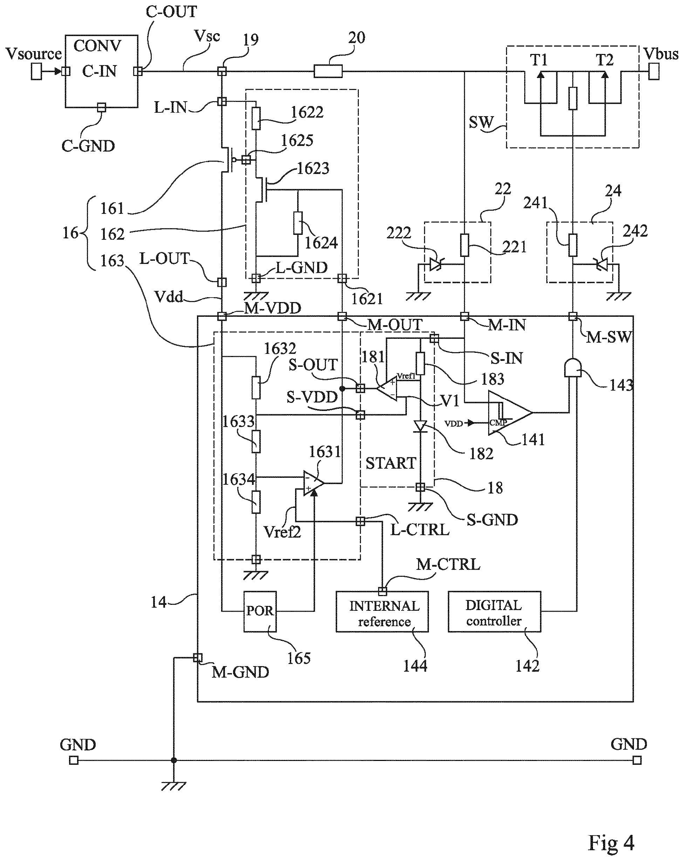

La figure 4 illustre de manière plus détaillée et sous la forme d'un circuit électronique, un mode de réalisation du dispositif 10 de la figure 2.

Dans l'exemple de la figure 4, la borne M-IN du module 14 est reliée à la borne C-OUT, donc à la borne 19, par une résistance 20 en série avec un dispositif passif 22 de protection contre les surtensions, la résistance 20 étant connectée à la borne C-OUT. Le dispositif 22 comprend ici une résistance 221 connectée entre la résistance 20 et la borne M-IN, et une diode Zener 222 dont l'anode est connectée à une borne au potentiel de référence GND et dont la cathode est connectée à la borne M-IN.

Dans l'exemple de la figure 4, l'interrupteur SW comprend deux transistors T1 et T2 en série, reliant la borne C-OUT du convertisseur 12 (donc la borne 19) à la borne de sortie du dispositif 10 fournissant la tension Vbus, le transistor T1 étant du côté de la borne C-OUT. Plus précisément, une borne de conduction du transistor T1 est connectée au noeud de connexion entre la résistance 20 et le dispositif 22. Les transistors T1 et T2 sont ici des transistors MOS à canal P, la source et la grille du transistor T1 étant reliées, de préférence connectées, respectivement à la source et à la grille du transistor T2. L'interrupteur SW comprend en outre une résistance R reliant les sources des transistors T1 et T2 aux grilles des transistors T1 et T2. Les grilles des transistors T1 et T2 constituent la borne de commande de l'interrupteur SW. La borne de commande de l'interrupteur SW est reliée à la borne de M-SW du module 14, dans cet exemple par un dispositif passif 24 de protection contre les surtensions. Le dispositif 24 est par exemple identique au dispositif 22, la diode et la résistance du dispositif 24 étant respectivement référencées 242 et 241.

En figure 4, le régulateur 16 comprend un transistor 161, par exemple un transistor MOS, par exemple à canal P, dont les bornes de conduction sont respectivement connectées aux bornes L-IN et L-OUT. En fonctionnement, le transistor 161 est commandé de manière à mettre en oeuvre le procédé décrit en relation avec la figure 3. De préférence le transistor 161 est un transistor de puissance.

Le régulateur 16 comprend en outre un circuit 162 de commande ou pilotage du transistor 161. Le circuit 162 est configuré pour fournir un signal de commande à la borne de commande du transistor 161, déterminé à partir d'un signal reçu sur une borne 1621 du circuit 162. Le circuit 162 comprend une résistance 1622 et un transistor 1623 connectés en série entre la borne L-IN (donc la borne 19) et la borne L-GND. Une résistance 1624 est connectée entre la borne de commande du transistor 1622, ici la borne 1621, et la borne L-GND. Le noeud de connexion 1625 entre le transistor 1623 et la résistance 1622 est connecté à la borne de commande du transistor 161. Dans cet exemple où le transistor 161 est à canal P, le transistor 1623 est canal N et a sa source et son drain connectés respectivement à la borne L-GND et à la résistance 1622.

Le régulateur 16 comprend en outre un circuit 163 configuré pour fournir, à la borne 1621 du circuit 162, un signal représentatif de l'écart entre la tension Vdd et la tension de seuil Vdd-th si une puissance d'alimentation a déjà été négociée, ou entre la tension Vdd et la tension de seuil Vdd-start-th sinon. Ce signal est fourni par la sortie d'un amplificateur différentiel 1631. La sortie de l'amplificateur 1631 est connectée à la borne 1621. Dans l'exemple de la figure 4, le circuit 163 est inclus dans le module 14 et la sortie de l'amplificateur 1631 constitue une borne de sortie M-OUT du module 14, connectée à la borne 1621 du circuit 162. En variante, le circuit 163 est externe au module 14.

Une entrée, de préférence non inverseuse (+), de l'amplificateur 1631 est configurée pour recevoir une tension de référence Vref2 représentative de la consigne Vsc-neg ou Vsc-start selon le cas, donc de la tension de seuil Vdd-th ou Vdd-start-th selon le cas. La tension Vref2 est fournie par un circuit 144 (INTERNAL reference) du module 14. Dans cet exemple où le circuit 163 fait partie du module 14, la borne du circuit 144 fournissant la tension Vref2 correspond à la borne M-CTRL décrite en relation avec la figure 2, et l'entrée de l'amplificateur 1631 qui reçoit la tension Vref2 correspond à la borne L-CTRL décrit en relation avec la figure 2. A titre d'exemple, la tension Vref2 est égale à une fraction de la valeur de consigne de la tension Vsc, ou, autrement dit, est égale à A*Vsc-start ou A*Vsc-neg selon le cas, A étant inférieur à 1.

Une autre entrée de l'amplificateur 1631, de préférence inverseuse (-), est couplée à la borne M-VDD pour recevoir une tension V2 représentative de la tension Vdd. Plus particulièrement, le circuit 163 comprend un pont résistif diviseur de tension. Le pont diviseur comprend ici trois résistances 1632, 1633 et 1634 connectées en série entre la borne M-VDD (L-OUT) et une borne au potentiel de référence GND, la résistance 1632 étant connectée à la borne M-VDD et la résistance 1634 étant connectée à la borne au potentiel GND. La tension V2 est disponible au niveau du noeud de connexion entre les résistances 1633 et 1634.

Dans ce mode de réalisation, l'amplificateur 1631 comprend en outre une borne d'activation recevant un signal d'activation d'un circuit 165 (POR) du module 14. Le circuit 165 POR (pour "power on reset") est en outre connecté à la borne M-VDD. Le circuit 165 est configuré pour fournir un signal d'activation à la borne d'activation de l'amplificateur 1631 lorsque la tension Vdd est sensiblement égale, de préférence égale, ou supérieure à la tension Vdd-lim. Ainsi, le circuit 163 n'est actif qu'à partir de l'instant t2 en figure 3.

Bien que le circuit 165 soit représenté ici comme faisant partie du module 14, ce circuit 165 peut être externe au module 14. En particulier, dans le cas où le circuit 163 est externe au module 14, le circuit 165 peut faire partie du circuit 163, donc du régulateur 16.

Dans l'exemple de la figure 4, le circuit de démarrage 18 comprend un amplificateur différentiel 181. Une borne d'alimentation de l'amplificateur 181 est connectée à la borne S-IN du circuit 18, elle-même connectée à la borne M-IN du module 14. Ainsi, l'amplificateur 181 est alimenté par une tension sensiblement égale à la tension Vsc. De préférence, l'amplificateur différentiel 181 est un amplificateur basse puissance ("low-power"), c'est-à-dire qu'il peut fonctionner avec une puissance d'alimentation relativement faible, par exemple avec un courant d'alimentation de l'ordre de quelques microampères, par exemple moins de 10 µA, et une tension d'alimentation de l'ordre de 2 à 3 V. La sortie de l'amplificateur 181 constitue la sortie S-OUT du circuit 18. La sortie S-OUT du circuit 18 est connectée à la borne M-OUT, donc à la borne 1621 du circuit 161 qui correspond à la borne L-START en figure 2. Une entrée de l'amplificateur 181, de préférence l'entrée non inverseuse (+) reçoit une tension de référence Vref1. La tension Vref1 n'a pas besoin d'être précise et ne sert que pendant la phase de démarrage du circuit 10. Par exemple, la tension Vref1 est fixée par la chute de tension aux bornes d'un composant, par exemple par la tension de seuil d'une ou plusieurs diodes en série ou par un ou plusieurs transistors MOS en série. Dans l'exemple de la figure 4, la tension Vref1 est fixée par la tension de seuil d'une diode 182. La diode 182 est connectée en série avec une résistance 183, entre les bornes S-IN et S-GND, la cathode de la diode étant connectée à la borne S-GND et le noeud de connexion entre la diode 182 et la résistance 183 fournissant la tension Vref1. Une autre entrée de l'amplificateur 181, de préférence inverseuse (-), est couplée à la borne M-VDD pour recevoir une tension V1 représentative de la tension Vdd. Cette autre entrée de l'amplificateur 181 correspond donc à la borne S-VDD de la figure 2.

Dans cet exemple, la tension V1 est disponible au niveau du noeud de connexion entre les résistances 1632 et 1633. Le circuit 163 du régulateur 16 partage donc son pont diviseur de tension avec le circuit 18. En variante, un pont diviseur supplémentaire peut être prévu entre la borne S-VDD et l'entrée de l'amplificateur recevant la tension V1, la borne S-VDD étant alors connectée à la borne M-VDD comme cela est représenté en figure 2.

Dans cet exemple, le circuit 18 fait partie du module 14. En variante, le circuit 18 peut être externe au module 14.

En figure 4, le module 14 comprend en outre un comparateur à hystérésis 141. Une entrée du comparateur est connectée à la borne M-IN, l'autre entrée du comparateur étant connectée à la borne M-VDD (non représenté en figure 4) pour recevoir la tension Vdd. La sortie du comparateur 141 est reliée à la borne M-SW.

Dans le mode de réalisation représenté, le module 14 comprend un circuit 142 (Digital controller) de commande de l'interrupteur SW. La sortie du circuit 142 est reliée à la borne M-SW. Dans cet exemple, le module 14 comprend une porte ET 143 dont les entrées sont connectées aux sorties respectives du comparateur 141 et du circuit 142, et dont la sortie est connectée à la borne M-SW.

On notera qu'en figure 4, la borne C-DRIVE du convertisseur 12, la borne M-DRIVE du module 14, les bornes de communication M-CC1 et M-CC2 du module 14 et les bornes de communication M-CC1 et M-CC2 du dispositif 10 n'ont pas été représentées.

Lors d'une phase de démarrage du dispositif 10 de la figure 4, lorsque la tension Vsc augmente à partir d'une valeur nulle (à partir de l'instant t0 et jusqu'à l'instant t1 en figure 3), une tension non nulle s'établit sur la borne M-IN. Dès que cette tension est suffisante pour alimenter l'amplificateur 181 et pour fixer la tension Vref1, du fait que la tension Vdd, donc la tension V1, sont nulles, la tension de sortie de l'amplificateur 181 est non nulle. Cette tension non nulle se retrouve sur la borne de commande du transistor 1623 qui devient passant, ce qui entraîne que le transistor 161 devient passant à son tour. La tension Vdd est ensuite égale à la tension Vsc (de l'instant t0 à l'instant t1 en figure 3) ou à Vdd-lim (de l'instant t1 à l'instant t2 en figure 3) selon le cas. Dans l'exemple de la figure 4, la tension Vdd-lim est égale à Vref1*(1+(Ra/(Rb+Rc))), avec Ra, Rb et Rc les valeurs des résistances respectives 1632, 1633 et 1634. La valeur de la tension Vref1 et les valeurs Ra, Rb et Rc sont donc déterminées par la valeur Vdd-lim.

Le circuit 165 active alors le circuit 163 (instant t2, figure 3), c'est-à-dire l'amplificateur 1631. La tension V2 est égale à Vdd*(Rc/(Ra+Rb+Rc)), la tension Vref2 étant égale à A*Vsc-start.

Les valeurs des résistances Ra, Rb et Rc sont choisies de sorte que Rc/(Ra+Rb+Rc)<A, ou, autrement dit, pour que Rc/(Ra+Rb+Rc)=A/B avec B strictement supérieur à 1.

On considère tout d'abord le cas où la tension Vsc est égale à la valeur de consigne Vsc-start. La tension Vdd est alors égale à Vsc-start aux chutes de tension près dans le régulateur 16. En effet, la tension V2 est égale à Vdd*(Rc/(Ra+Rb+Rc)), donc à Vdd*(A/B). Comme la tension Vref2 est égale à A*Vsc-start et que la tension Vdd peut au mieux être égale à la tension Vsc, la tension Vref2 est supérieure à la tension V2. En choisissant B pour que l'écart entre les tensions Vref2 et V2 provoque une saturation de l'amplificateur 1631 à l'état haut, par exemple B égal à 1,25, on s'assure que les transistors 1623 et 161 soient passants. Il en résulte que la tension Vdd est bien égale à la valeur de consigne Vsc-start, aux chutes de tension près dans le transistor 161.

On considère maintenant le cas (non illustré en figure 3) où la tension Vsc augmente et s'éloigne de la valeur de consigne Vsc-start, par exemple suite à un défaut de fonctionnement du convertisseur 12. L'amplificateur 1631 fourni alors un signal de sortie tel que les tensions V2 et Vref2 sont égales. Ainsi, Vdd*(Rc/(Ra+Rb+Rc)) est égal à A*Vsc-start, ou, autrement dit, la tension Vdd est égale à B*Vsc-start, B*Vsc-start constituant la valeur de seuil Vdd-start-th. En outre, lorsque la tension Vsc devient supérieure à la consigne Vsc-start majorée par la valeur d'hystérésis du comparateur 141, la sortie de ce dernier bascule à l'état bas, ce qui entraîne l'ouverture de l'interrupteur SW dans le cas où l'interrupteur n'est pas déjà maintenu ouvert par la sortie à l'état bas du circuit 142.

Le fonctionnement du régulateur 16 décrit ci-dessus, lorsque le régulateur est commandé par son circuit 163, c'est-à-dire par la tension Vref2, plutôt que par le circuit de démarrage 18, s'applique également quand la consigne Vsc-start est remplacée par une consigne Vsc-neg, la tension Vref2 étant alors égale à A*Vsc-neg, et la tension de seuil Vdd-th étant alors égale B*Vsc-neg.

Divers modes de réalisation et variantes ont été décrits. L'homme de l'art comprendra que certaines caractéristiques de ces divers modes de réalisation et variantes pourraient être combinées. En particulier, le dispositif 10 peut être utilisé avec d'autres câbles que des câbles de type USB-C associés à la technologie USB-PD, par exemple pour adapter la puissance d'une source d'alimentation et protéger le dispositif alimenté par cette alimentation adaptée.

Enfin, la mise en oeuvre pratique des modes de réalisation et variantes décrits est à la portée de l'homme du métier à partir des indications fonctionnelles données ci-dessus.

## Revendications

1. Dispositif (10) comprenant :
une première borne (19) destinée à recevoir une première tension continue (Vsc) ;
un interrupteur (SW) reliant sélectivement la première borne (19) à une deuxième borne de sortie (Vbus) du dispositif ;
un circuit de commande (14) de l'interrupteur comprenant une troisième borne (M-VDD) destinée à recevoir une deuxième tension continue (Vdd) ; et
un régulateur (16) linéaire de tension à faible chute, LDO, connecté entre les première et troisième bornes,
dans lequel le régulateur est configuré pour fournir la deuxième tension à partir de la première tension, et le circuit de commande (14) de l'interrupteur (SW) est configuré pour comparer la première tension (Vsc) à la deuxième tension (Vdd), et pour commander l'état ouvert ou fermé de l'interrupteur en fonction du résultat de la comparaison.

2. Dispositif selon la revendication 1, dans lequel le circuit de commande (14) de l'interrupteur (SW) comprend un comparateur à hystérésis (141) dont une première entrée est reliée à la première borne (19), dont une deuxième entrée est connectée à la troisième borne (M-VDD), et dont une sortie est couplée à une borne de commande de l'interrupteur (SW).

3. Dispositif selon la revendication 1 ou 2, dans lequel, lorsque la première tension (Vsc) augmente à partir d'une valeur de consigne (Vsc-start, Vsc-neg), le régulateur (16) est configuré pour maintenir la deuxième tension (Vdd) inférieure ou égale à une tension de seuil (Vdd-start-th, Vdd-th), de préférence supérieure à la valeur de consigne.

4. Dispositif selon la revendication 3, dans lequel la tension de seuil (Vdd-start-th, Vdd-th) est déterminée à partir de la valeur de consigne (Vsc-start, Vsc-neg).

5. Dispositif selon la revendication 3 ou 4, dans lequel le régulateur (16) comprend :
un transistor (161), de préférence un transistor de puissance, dont les bornes de conduction sont respectivement connectées aux première (19) et troisième bornes (M-VDD) ;
un premier circuit (162) configuré pour commander le transistor (161) à partir d'un signal disponible sur une quatrième borne (1621) ; et
un deuxième circuit (163) configuré pour fournir, à la quatrième borne, un signal représentatif de l'écart entre la valeur de la deuxième tension (Vdd) et la valeur de seuil (Vdd-start-th, Vdd-th).

6. Dispositif selon la revendication 5, dans lequel le deuxième circuit (163) comprend un amplificateur différentiel (1631) dont une entrée, de préférence non inverseuse, est configurée pour recevoir une tension représentative de la valeur de seuil (Vdd-start-th, Vdd-th), dont une autre entrée, de préférence inverseuse, est couplée à la troisième borne (M-VDD), et dont une sortie (S-OUT) est connectée à la quatrième borne (1621).

7. Dispositif selon la revendication 5 ou 6, comprenant en outre un troisième circuit (165) configuré pour activer le deuxième circuit (162) lorsque la deuxième tension (Vdd) devient supérieure à une tension limite (Vdd-lim).

8. Dispositif selon les revendications 6 et 7, dans lequel le troisième circuit (162) est configuré pour activer l'amplificateur différentiel (1631) du deuxième circuit (162) lorsque la deuxième tension (Vdd) est sensiblement supérieure ou égale à la tension limite (Vdd-lim).

9. Dispositif selon l'une quelconque des revendications 1 à 8, comprenant en outre un circuit de démarrage (18) du régulateur (16), alimenté électriquement par la première tension (Vsc).

10. Dispositif selon la revendication 9 et la revendication 7 ou 8, dans lequel le circuit de démarrage (18) est configuré pour fournir, à la quatrième borne (1621) et alors que le deuxième circuit (163) est inactif, un signal tel que la deuxième tension (Vdd) augmente avec la première tension (Vsc) jusqu'à la tension limite (Vdd-lim).

11. Dispositif selon la revendication 10, dans lequel le signal fourni à la quatrième borne (1621) par le circuit de démarrage (18) est représentatif de l'écart entre la deuxième tension (Vdd) et une tension de référence (Vref1).

12. Dispositif selon la revendication 11, dans lequel le circuit de démarrage (18) comprend un amplificateur différentiel (181), de préférence un amplificateur différentiel faible puissance, dont une entrée, de préférence non inverseuse, est couplée à une source (182) de la tension de référence (Vref1), dont une autre entrée, de préférence inverseuse, est couplée à la deuxième borne (M-VDD), et dont une sortie est connectée à la quatrième borne (1621), l'amplificateur différentiel étant alimenté par la première tension (Vsc).

13. Dispositif selon la revendication 12, dans lequel la source de la tension de référence (Vref1) est alimentée par la première tension (Vsc), la source de tension comprenant de préférence une ou plusieurs diodes (182) dont la ou les tensions de seuil déterminent la tension de référence.

14. Dispositif selon l'une quelconque des revendications 1 à 13, dans lequel la première borne (19) et/ou la borne de commande de l'interrupteur (SW) sont couplées chacune à une borne d'application d'un potentiel de référence (GND), de préférence la masse, par une diode respective (222, 242), de préférence une diode Zener.

## Patentansprüche

1. Eine Vorrichtung (10), die Folgendes aufweist:
einen ersten Anschluss (19), der zum Empfang einer ersten Gleichspannung (Vsc) bestimmt ist;
einen Schalter (SW), der den ersten Anschluss (19) selektiv mit einem zweiten Ausgangsanschluss (Vbus) der Vorrichtung verbindet;
eine Steuerschaltung (14) des Schalters, die einen dritten Anschluss (M-VDD) aufweist, der dazu bestimmt ist, eine zweite Gleichspannung (Vdd) zu empfangen; und
einen linearen Low-Dropout-Spannungsregler (16), LDO, der zwischen dem ersten und dem dritten Anschluss angeschlossen ist,
wobei der Regler so konfiguriert ist, dass er die zweite Spannung auf der Grundlage der ersten Spannung bereitstellt, und die Steuerschaltung (14) des Schalters (SW) so konfiguriert ist, dass sie die erste Spannung (Vsc) mit der zweiten Spannung (Vdd) vergleicht und den offenen oder geschlossenen Zustand des Schalters in Abhängigkeit von dem Ergebnis des Vergleichs steuert.

2. Vorrichtung nach Anspruch 1, wobei die Steuerschaltung (14) des Schalters (SW) einen Hysteresekomparator (141) aufweist, wobei ein erster Eingang mit dem ersten Anschluss (19) gekoppelt ist, ein zweiter Eingang mit dem dritten Anschluss (M-VDD) verbunden ist und ein Ausgang mit einem Steueranschluss des Schalters (SW) gekoppelt ist.

3. Vorrichtung nach Anspruch 1 oder 2, wobei, wenn die erste Spannung (Vsc) von einem Zielwert (Vsc-start, Vsc-neg) ansteigt, der Regler (16) so konfiguriert ist, dass er die zweite Spannung (Vdd) niedriger als oder gleich einer Schwellenspannung (Vdd-start-th, Vdd-th), vorzugsweise höher als der Zielwert, hält.

4. Vorrichtung nach Anspruch 3, wobei die Schwellenspannung (Vdd-start-th, Vdd-th) basierend auf dem Zielwert (Vsc-start, Vsc-neg) bestimmt wird.

5. Vorrichtung nach Anspruch 3 oder 4, wobei der Regler (16) Folgendes aufweist:
einen Transistor (161), vorzugsweise einen Leistungstransistor, dessen Leitungsanschlüsse jeweils mit dem ersten (19) und dritten Anschluss (M-VDD) verbunden sind;
eine erste Schaltung (162), die so konfiguriert ist, dass sie den Transistor (161) basierend auf einem an einem vierten Anschluss (1621) verfügbaren Signal steuert; und
eine zweite Schaltung (163), die so konfiguriert ist, dass sie an den vierten Anschluss ein Signal liefert, das die Differenz zwischen dem Wert der zweiten Spannung (Vdd) und dem Schwellenwert (Vdd-start-th, Vdd-th) darstellt.

6. Vorrichtung nach Anspruch 5, wobei die zweite Schaltung (163) einen Differenzverstärker (1631) aufweist, wobei ein Eingang, vorzugsweise nicht-invertierend, so konfiguriert ist, dass er eine für den Schwellenwert (Vdd-start-th, Vdd-th) repräsentative Spannung empfängt, ein weiterer Eingang, vorzugsweise invertierend, mit dem dritten Anschluss (M-VDD) verbunden ist und ein Ausgang (S-OUT) mit dem vierten Anschluss (1621) verbunden ist.

7. Vorrichtung nach Anspruch 5 oder 6, ferner mit einer dritten Schaltung (165), die so konfiguriert ist, dass sie die zweite Schaltung (162) aktiviert, wenn die zweite Spannung (Vdd) höher als eine Spannungsgrenze (Vdd-lim) wird.

8. Vorrichtung nach Anspruch 6 und 7, wobei die dritte Schaltung (162) so konfiguriert ist, dass sie den Differenzverstärker (1631) der zweiten Schaltung (162) aktiviert, wenn die zweite Spannung (Vdd) wesentlich höher als oder gleich der Spannungsgrenze (Vdd-lim) ist.

9. Vorrichtung nach einem der Ansprüche 1 bis 8, die ferner eine Startschaltung (18) zum Starten des Reglers (16) aufweist, die von der ersten Spannung (Vsc) versorgt wird.

10. Vorrichtung nach Anspruch 9 und Anspruch 7 oder 8, wobei die Startschaltung (18) so konfiguriert ist, dass sie an den vierten Anschluss (1621) und bei inaktiver zweiter Schaltung (163) ein solches Signal liefert, dass die zweite Spannung (Vdd) mit der ersten Spannung (Vsc) bis zur Spannungsgrenze (Vdd-lim) zunimmt.

11. Vorrichtung nach Anspruch 10, wobei das von der Startschaltung (18) an den vierten Anschluss (1621) gelieferte Signal repräsentativ für die Differenz zwischen der zweiten Spannung (Vdd) und einer Referenzspannung (Vref1) ist.

12. Vorrichtung nach Anspruch 11, wobei die Startschaltung (18) einen Differenzverstärker (181), vorzugsweise einen Low-Power-Differenzverstärker, aufweist, von dem ein Eingang, vorzugsweise nicht-invertierend, mit einer Quelle (182) der Referenzspannung (Vref1) verbunden ist, ein weiterer Eingang, vorzugsweise invertierend, mit dem zweiten Anschluss (M-VDD) verbunden ist und ein Ausgang mit dem vierten Anschluss (1621) verbunden ist, wobei der Differenzverstärker von der ersten Spannung (Vsc) gespeist wird.

13. Vorrichtung nach Anspruch 12, wobei die Quelle der Referenzspannung (Vref1) von der ersten Spannung (Vsc) gespeist wird, wobei die Spannungsquelle vorzugsweise eine oder mehrere Dioden (182) aufweist, deren eine oder mehrere Schwellenspannungen die Referenzspannung bestimmen.

14. Vorrichtung nach einem der Ansprüche 1 bis 13, wobei der erste Anschluss (19) und/oder der Steueranschluss des Schalters (SW) über jeweils eine Diode (222, 242), vorzugsweise eine Zenerdiode, mit einem Anschluss zum Anlegen eines Bezugspotentials (GND), vorzugsweise Masse, verbunden sind.

## Claims

1. A device (10) comprising:
a first terminal (19) intended to receive a first DC voltage (Vsc);
a switch (SW) selectively coupling the first terminal (19) to a second output terminal (Vbus) of the device;
a control circuit (14) of the switch comprising a third terminal (M-VDD) intended to receive a second DC voltage (Vdd); and
a low-dropout linear voltage regulator (16), LDO, connected between the first and third terminals,
wherein the regulator is configured to provide the second voltage based on the first voltage, and the control circuit (14) of the switch (SW) is configured to compare the first voltage (Vsc) with the second voltage (Vdd), and to control the open or closed state of the switch as a function of the result of the comparison.

2. The device according to claim 1, wherein the control circuit (14) of the switch (SW) comprises an hysteresis comparator (141) a first input of which is coupled to the first terminal (19), a second input of which is connected to the third terminal (M-VDD), and an output of which is coupled to a control terminal of the switch (SW).

3. The device according to claim 1 or 2, wherein, when the first voltage (Vsc) increases from a target value (Vsc-start, Vsc-neg), the regulator (16) is configured to maintain the second voltage (Vdd) lower than or equal to a threshold voltage (Vdd-start-th, Vdd-th), preferably higher than the target value.

4. The device according to claim 3, wherein the threshold voltage (Vdd-start-th, Vdd-th) is determined based on the target value (Vsc-start, Vsc-neg).

5. The device according to claim 3 or 4, wherein the regulator (16) comprises:
a transistor (161), preferably a power transistor, the conduction terminals of which are respectively connected to the first (19) and third terminals (M-VDD);
a first circuit (162) configured to control the transistor (161) based on a signal available on a fourth terminal (1621); and
a second circuit (163) configured to provide, to the fourth terminal, a signal representative of the difference between the value of the second voltage (Vdd) and the threshold value (Vdd-start-th, Vdd-th).

6. The device according to claim 5, wherein the second circuit (163) comprises a differential amplifier (1631) an input of which, preferably non-inverting, is configured to receive a voltage representative of the threshold value (Vdd-start-th, Vdd-th), a further input of which, preferably inverting, is linked to the third terminal (M-VDD), and an output (S-OUT) of which is connected to the fourth terminal (1621).

7. The device according to claim 5 or 6, further comprising a third circuit (165) configured to activate the second circuit (162) when the second voltage (Vdd) becomes higher than a voltage limit (Vdd-lim).

8. The device according to claims 6 and 7, wherein the third circuit (162) is configured to activate the differential amplifier (1631) of the second circuit (162) when the second voltage (Vdd) is substantially higher than or equal to the voltage limit (Vdd-lim).

9. The device according to any of claims 1 to 8, further comprising a starting circuit (18) for starting the regulator (16), which is supplied by the first voltage (Vsc) .

10. The device according to claim 9 and the claim 7 or 8, wherein the starting circuit (18) is configured to provide, to the fourth terminal (1621) and while the second circuit (163) is inactive, a signal such that the second voltage (Vdd) increases with the first voltage (Vsc) up to the voltage limit (Vdd-lim).

11. The device according to claim 10, wherein the signal provided to the fourth terminal (1621) by the starting circuit (18) is representative of the difference between the second voltage (Vdd) and a reference voltage (Vref1).

12. The device according to claim 11, wherein the starting circuit (18) comprises a differential amplifier (181), preferably a low-power differential amplifier, an input of which, preferably non-inverting, is linked to a source (182) of the reference voltage (Vref1), a further input of which, preferably inverting, is linked to the second terminal (M-VDD), and an output of which is connected to the fourth terminal (1621), the differential amplifier being supplied by the first voltage (Vsc).

13. The device according to claim 12, wherein the source of the reference voltage (Vref1) is supplied by the first voltage (Vsc), the voltage source preferably comprising one or more diodes (182) the one or more threshold voltages of which determine the reference voltage.

14. The device according to any of claims 1 to 13, wherein the first terminal (19) and/or the control terminal of the switch (SW) are each linked to an application terminal for applying a reference potential (GND), preferably ground, by a respective diode (222, 242), preferably a Zener diode.
